# EUROPEAN PATENT APPLICATION

(11) **EP 2 107 062 A1**
(43) Date of publication of application: **07.10.2009**
(21) Application number: 08154031.2
(22) Date of filing: 03.04.2008
(51) Int. Cl.: C07F 7/08, C09K 11/06, H01L 51/00

(54) **Naphthyl-substituted anthracene derivatives and their use in organic light-emitting diodes**

(71) Applicant: SOLVAY (Société Anonyme), 1050 Bruxelles (BE)
(72) Inventor: Mazur, Wieslaw Adam, MASO, OH 45040 (US); Georgieva, Angelina, CINCINATTI, OH 45219 (US)
(74) Representative: Jacques, Philippe

(57) **Abstract**

The present invention relates to anthracene derivative compounds represented by Formula I: 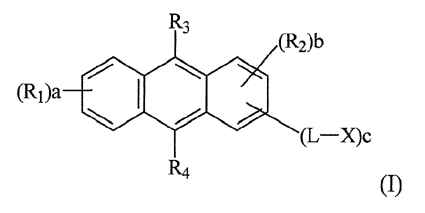 or a pharmaceutically acceptable salt thereof, with R₁, R₂, R₃, R₄, L, X, a, b, and c defined herein. The compounds of the present invention, having a substituted silicon atom introduced in anthracene, advantageously improves the solubility of anthracene without any adverse effects, thereby allowing solvent-processing. Also disclosed are light emitting materials comprising such compounds, the use of such light emitting materials, and organic light emitting devices comprising such light emitting materials.

## Description

### FIELD OF THE INVENTION

The present invention relates to novel anthracene derivatives, light-emitting materials comprising such derivatives, the use of such light-emitting materials in organic light-emitting diodes, and light-emitting devices comprising such materials and capable of converting electric energy to light.

### BACKGROUND OF THE INVENTION

Today, various display devices are being actively researched and developed, particularly those based on electroluminescence (EL) from organic materials.

In contrast to photoluminescence, i.e., light emission from an active material due to optical absorption and relaxation by radioactive decay of an excited state, EL refers to a non-thermal generation of light resulting from applying an electric field to a substrate. In EL, excitation is accomplished by recombining the charge carriers of contrary signs, e.g., electrons and holes, injected into an organic semiconductor, in the presence of an external circuit.

A simple prototype of an organic light-emitting diode (OLED), e.g., a single layer OLED, is typically composed of a thin film made from an active organic material, which is sandwiched between two electrodes. One electrode needs to be semi-transparent in order to observe the light emission from the organic layer. Typically, an indium tin oxide (ITO)-coated glass substrate is used as the anode.

Meanwhile, efforts have been made to use compounds containing an anthracene group in OLEDs since the early 1960s. In 1965, Helfrich and Pope reported the realization of blue organic electroluminescence, using a single crystal of anthracene for the first time. However, a high voltage is required to emit light when using a single crystal of anthracene, and there are many problems in commercialization due to the short life of the device (W. Helfrich, W. G. Schneider, Phys. Rev. Lett. 14:229 (1965); M. Pope, H. Kallmann, J. Giachino, J. Chem. Phys., 42:2540 (1965)). Further, anthracene has a high melting point and is very insoluble; thus, it cannot be readily solution processed. As a result, for applications like OLEDs, prior art materials, such as anthracene, are usually deposited as a thin film by vacuum deposition, which is an expensive processing technique that is unsuitable for the fabrication of large-area films. In order to improve the solubility of anthracene, several substituted derivatives have been synthesized so far.

For example, U.S. Patent Application Publication No. US 2002/0028346 (EASTMAN KODAK COMPANY) discloses an organic multilayer electroluminescent device including an anode and cathode, and including therebetween a hole transport layer; and an electron transport layer disposed in operative relationship with the hole transport layer; wherein the hole transport layer includes an anthracene compound having the formula: 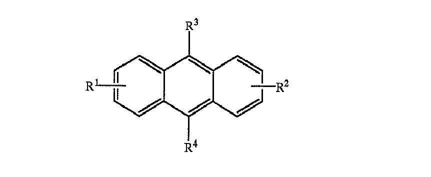 wherein:
substituents R¹, R², R³ and R⁴ are each individually hydrogen, or alkyl of from 1 to 24 carbon atoms; aryl or substituted aryl of from 5 to 20 carbon atoms; or heteroaryl or substituted heteroaryl of from 5 to 24 carbon atoms; or fluorine, chlorine, bromine; or cyano group. Another example of the hole transport layer is an anthracene derivative having the formula: 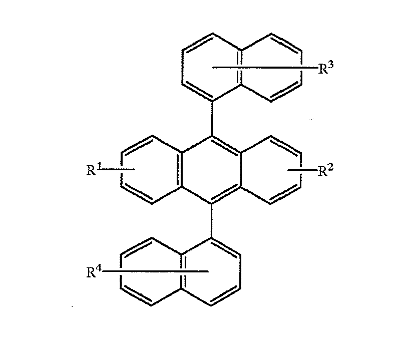
wherein:
substituents R¹, R², R³ and R⁴, are each individually hydrogen, or alkyl of from 1 to 24 carbon atoms; aryl or substituted aryl of from 5 to 20 carbon atoms; or heteroaryl or substituted heteroaryl of from 5 to 24 carbon atoms; or fluorine, chlorine, bromine; or cyano group.

U.S. Patent Application Publication No. US 2004/0018380 (XEROX CORPORATION) discloses a device including: an anode; a cathode; and a luminescent region between the cathode and the anode, wherein the luminescent region includes an anthracene derivative compound and a triazine derivative compound. Various anthracene derivative compounds, such as halogen-, alkoxy-, alkyl-, aryl- or heteroaryl-substituted derivatives, are disclosed.

PCT International Publication No. WO 2007/065548 (MERCK PATENT GMBH) relates to blends of organic material, the use of such blends in organic electroluminescent devices, and organic electroluminescent devices containing such blends. Several 9,10-dinaphthyl-substituted anthracene derivatives are disclosed as examples of the blends of organic material.

A number of U.S. patent application publications, all assigned to LG CHEM LTD., disclose using anthracene derivatives having various substituents as materials for OLED. For example, imidazole functional groups (US 2003/0165715); thiophenyl groups (US 2004/0067387); a phenyl group, an 1-naphthyl group, a 2-naphthyl group, and a pyrene (US 2006/0046097); cycloalkane fused to anthracene (US 2007/0059556); vinyl and acetylenyl groups (US 2007/0202355); and anthracenyl group (US 2007/0202355) have been introduced in different positions of the anthracene ring.

In addition, Kan et al. reported the use of anthracene derivatives having tetramethyl and dinaphthyl substituents for blue electroluminescence (Kan et al., Synthetic Metals, 141:245 (2004)), while Ho et al. described the preparation of 1-methyl-9,10-di(1-naphthyl)anthracene for efficient deep blue emission (Ho et al., Applied Physics Letter, 89:25903 (2006)).

However, the above-mentioned anthracene derivatives disclosed in the prior art still require vacuum processing when used in OLEDs. In addition, even with a good solubility, the other functional properties of the above anthracene derivatives are adversely affected and, thus, the performance of OLEDs prepared with such anthracene derivatives are not so improved. Therefore, it would be desirable to have anthracene derivatives that are capable of solution processing while maintaining other beneficial properties.

### BRIEF DESCRIPTION OF THE DRAWINGS

Figure 1 is a cross-sectional view of a display device containing the organic light emitting device of the present invention.
Figure 2 shows the current density and brightness of the light emitting device described in Example 2 as a function of driving voltage.
Figure 3 shows an electroluminescent spectrum of the light emitting device described in Example 2. The abscissa represents the wavelength in nm, while the ordinate stands for emission intensity in arbitrary units

### DETAILED DESCRIPTION OF THE INVENTION

The inventors of the present invention have conducted studies on the synthesis of anthracene derivatives having a novel structure and found that it is possible to improve the solubility of anthracene derivatives while maintaining all other beneficial functional properties as the light emitting material of the organic light emitting device, by introducing a substituted silicon group onto an anthracene compound.

It is thus an object of the present invention to provide a light emitting material comprising an anthracene derivative compound having a silicon atom.

It is another object of the present invention to use said anthracene derivatives as light emitting material and an organic light emitting device comprising said light emitting material.

The present invention relates to an anthracene derivative compound represented by Formula I: 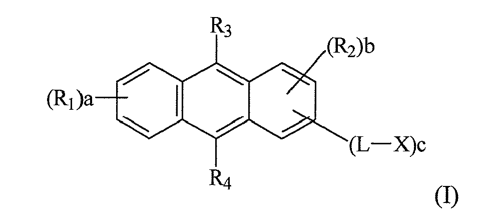 wherein:
R₁, R₂, R₃, and R₄ are the same or different at each occurrence and independently selected from the group consisting of -H, halogen, -NO₂, -CN, a straight or branched C₁₋₂₀ alkyl, a C₃₋₂₀ cyclic alkyl, a straight or branched C₁₋₂₀ alkoxy, a C₁₋₂₀ dialkylamino, a C₄₋₁₄ aryl, and a C₄₋₁₄ heteroaryl which may be substituted by one or more non aromatic radicals, wherein a plurality of substituents R₁, R₂, R₃, R₄ may in turn together form a further mono- or polycyclic ring system, optionally aromatic;
L is a single bond or a divalent radical derived from at least one selected from the group consisting of: a straight or branched C₁₋₂₀ alkyl, a C₃₋₂₀ cyclic alkyl, a straight or branched C₁₋₂₀ alkoxy, a C₁₋₂₀ dialkylamino, a C₄₋₁₄ aryl, and a C₄₋₁₄ heteroaryl which may be substituted by one or more non aromatic radicals, wherein a plurality of substituents L may in turn together form a further mono- or polycyclic ring system, optionally aromatic, with the proviso that at least one of R₁-R₄ and L includes a naphthyl moiety;
X is selected from the group consisting of -SiR₅R₆R₇, wherein R₅, R₆ and R₇ are the same or different at each occurrence and independently selected from the group consisting of -H, halogen, -NO₂, -CN, a straight or branched C₁₋₂₀ alkyl, a C₃₋₂₀ cyclic alkyl, a straight or branched C₁₋₂₀ alkoxy, a C₁₋₂₀ dialkylamino, a C₄₋₁₄ aryl, and a C₄₋₁₄ heteroaryl which may be substituted by one or more non aromatic radicals, wherein a plurality of substituents R₅, R₆ and R₇ may in turn together form a further mono- or polycyclic ring system, optionally aromatic, with the proviso that all of R₅, R₆ and R₇ cannot be phenyl simultaneously; and
a, b and c are the same or different at each occurrence and are an integer from 0 to 4, wherein c>0 and b+c =4.

The term "alkyl group" as used herein refers to hydrocarbon radicals containing preferably 1 to 20, more preferably 1 to 10.. Specific examples thereof include, but are not limited to, methyl, ethyl, propyl, isopropyl, butyl, t-butyl, pentyl, hexyl, and heptyl groups.

The term "alkoxy group" as used herein refers to an alkyl group containing preferably 1 to 20, more preferably 1 to 10, covalently bound to an oxygen atom. Specific examples thereof include, but are not limited to, methoxy, ethoxy, propyloxy, isopropyloxy, butoxy, t-butoxy, pentyloxy, hexyloxy, and heptyloxy groups.

The term "cycloalkyl group" as used herein refers to cyclic hydrocarbon radicals containing preferably 3 to 20, more preferably 3 to 10, most preferably 5 or 6 carbon atoms,. Specific examples thereof include, but are not limited to, cyclopentyl and cyclohexyl groups.

The term "aryl group" as used herein refers to carbocyclic rings with the degree of unsaturation present as to impart aromaticity to the ring. Specific examples thereof include, but are not limited to, phenyl, naphthyl, anthracenyl, biphenyl, pyrenyl, and perylene groups.

The term "heteroaryl group" as used herein refers to a substituted or unsubstituted heterocyclic aromatic ring, which can be a five-member ring heterocycle, a six-member ring heterocycle, and ring-fused bicyclic heterocycle. Specific examples thereof include, but are not limited to, pyridyl, bipyridyl, acridyl, thiophene, imidazole, oxazole, thiazole, and quinolinyl groups.

The compounds of the present invention have a substituted silicon attached to an anthracene compound, where the substituted silicon advantageously improves the solubility of the anthracene derivative, allowing solution processing, such as spin-coating, with no adverse effect on the other properties.

Preferably, R₁,R₂, R₃, R₄ are the same or different at each occurrence and independently selected from the group consisting of H and 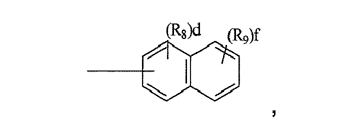 wherein R₈ and R₉ are the same or different at each occurrence and independently selected from the group consisting of -H, halogen, -NO₂, -CN, a straight or branched C₁₋₂₀ alkyl, a C₃₋₂₀ cyclic alkyl, a straight or branched C₁₋₂₀ alkoxy, a C₁₋₂₀ dialkylamino, a C₄₋₁₄ aryl, and a C₄₋₁₄ heteroaryl which may be substituted by one or more non aromatic radicals, wherein a plurality of substituents R₈ and R₉ may in turn together form a further mono- or polycyclic ring system, optionally aromatic; d is an integer from 0 to 3; and f is an integer from 0 to 4.

More preferably, at least one of R₅, R₆ and R₇ on the silicon atom contains more than one carbon atom, preferably alkyl having at least three carbon atoms, more preferably, *i*-propyl, *t*-butyl or *n*-octyl, in order to provide sufficient improvement in solubility.

Specific compounds of the present invention include an anthracene derivative compound of the present invention wherein both R₃ and R₄ are 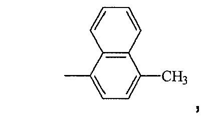 and L is single bond or 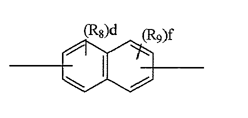 wherein R₈, R₉, d, and f are as defined above. More preferably, L is a divalent naphthyl radical.

Other specific compounds of the present invention include compounds represented by the following Formulae II, III, and IV:

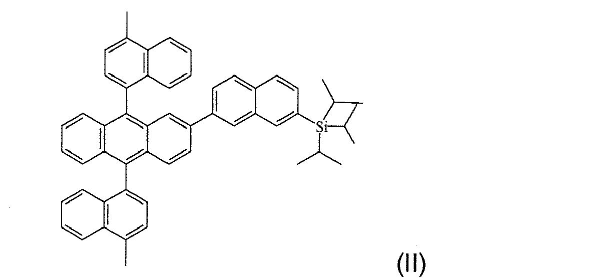

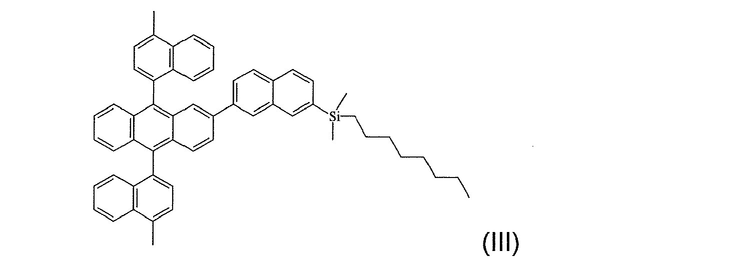

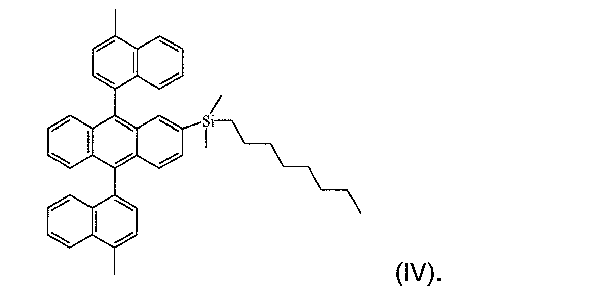

Excellent results were obtained with light emitting materials comprising the above compounds of Formulae II, III, and IV.

The anthracene compounds of the present invention show solubility with respect to organic solvents allowing for solvent processing of the materials in the manufacturing of electronic devices. Exemplary organic solvents used for dissolving anthracene derivatives include general purpose solvents, such as halogenated hydrocarbon solvents; alcohols; aromatics, such as anisole and alkylbenzene; amide solvents; phenol solvents; practically solvents used for the preparation of polyimide resin composition of the present invention. In particular, anisole, butylbenzene, and alcohols are preferred in view of their properties and practical usage. These solvents can be used singly or as a mixture.

The terms "soluble," "partially soluble," and "insoluble" used herein are defined as "being capable of being dissolved in a solvent," "when only part of a solute dissolves, leaving the other part undissolved and usually still visible," and "the inability of a substance to be dissolved in another substance," respectively.

Triaryl-substituted anthracene derivatives can be prepared by introducing aryl substituents to an anthracene derivative as shown in Schemes 1 & 2 below. Specifically, the triaryl-substituted anthracene derivatives are prepared by subjecting an aryl boronic acid or aryl boronic ester derivative (Ar₁-B(OH)₂ or Ar₁-B(OR)₂) having an aromatic substituent introduced to positions 9 and 10 and an arylhalide or heteroarylhalide derivative to a Suzuki coupling reaction in the presence of a Pd catalyst, as described in LOHSE et al., "The Palladium Catalyzed Suzuki Coupling of 2- and 4-Chloropyridines," Syn. Lett, 1:15 (1999).

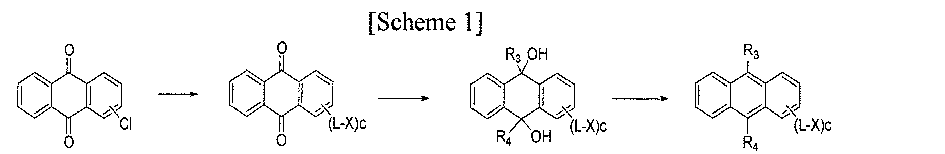

In the first reaction step, a boronic acid component in the form (RO)₂B-L-X where R is either H or alkyl, is used. In the second reaction step, R3Br and R4Br is added similarly as in Scheme 2 below.

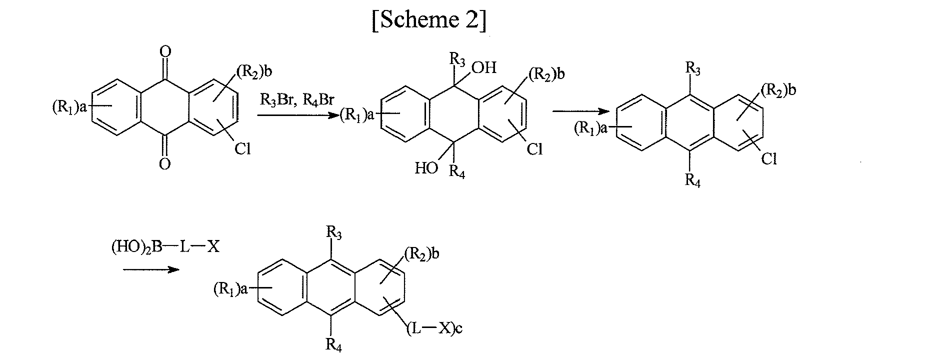

Syntheses of the claimed compound can be generally accomplished with either synthetic route (Scheme 1 or 2) although the choice of the route depends upon the specific synthetic target, that is, a combination of substituents R₁, R₂, R₃, R₄ and (L-X) in the target molecule. For some combinations, the route shown in Scheme 1 is more effective and for some others the route shown in Scheme 2 may be preferred.

For example, the trinaphthyl anthracene derivatives represented by Formulae II and III can be prepared with good to excellent yield by the method shown in Scheme 3 below.

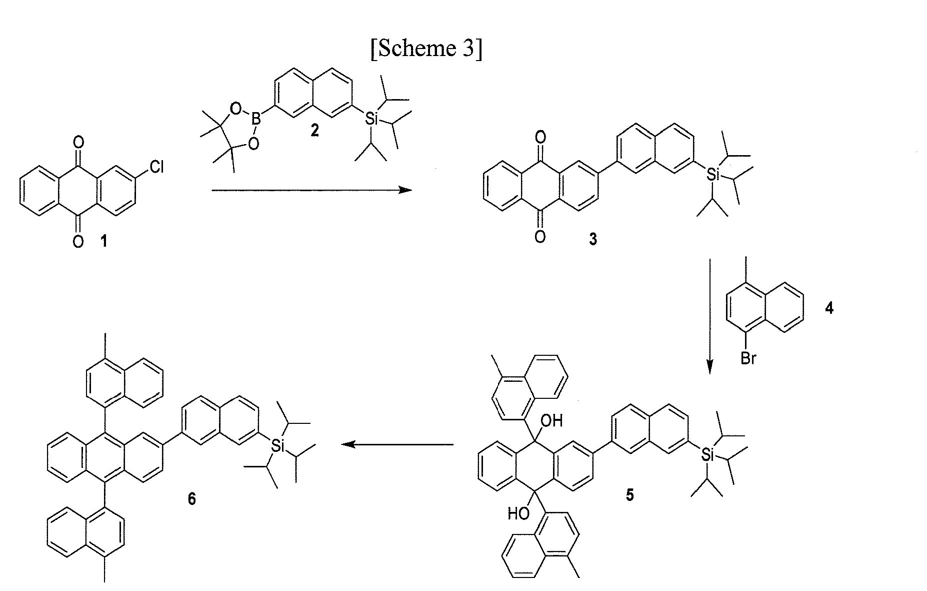

Thus, 2-chloro-9,10-anthraquinone is coupled with the naphthyl compound 2 by means of Suzuki reaction to give the intermediate 3 which is treated with a reagent derived from bromonaphthalene 4 and alkyl lithium, such as *n*-butyl or *t*-butyl lithium . The dialcohols 5 are subsequently aromatized, to produce compound 6.

In another embodiment of the present invention, the anthracene compound of the present invention having X (if L is a single bond) may be synthesized via a different reaction scheme, as shown in Scheme 4 below.

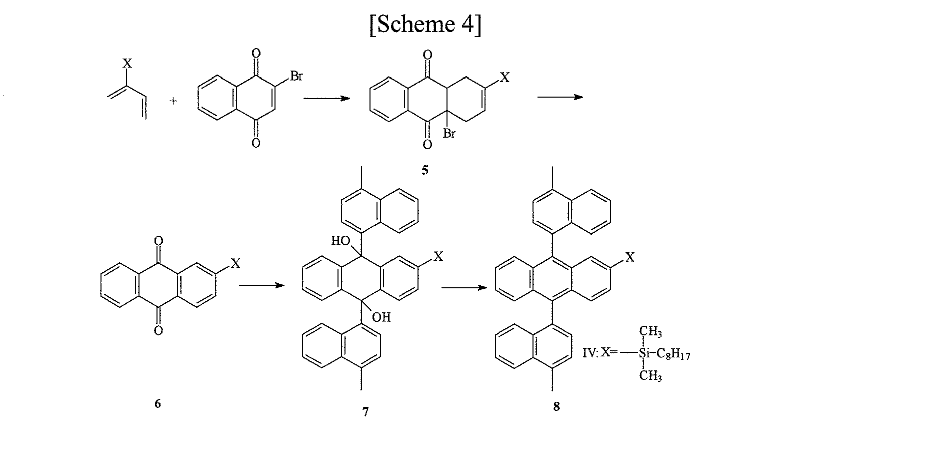

X may also be: 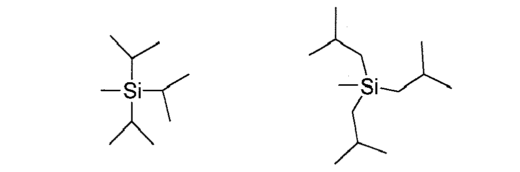 i.e. the Si substituents may be linear or branched alkyl radicals with 1 to 20 carbon atoms.

The first reaction step in above Scheme 4, which produces naphthaquinones (i.e., compound 5), is a (I have not seen D-A for this particular substitution pattern) Diels-Alder-type reaction (*see* K. C. Nicolaou et al, "The Diels-Alder Reaction in Total Synthesis," Angewandte Chemie International Edition, 2002, 41(10):1668-1698). The presence of the bromine substituent in anthraquinone facilitates the subsequent aromatization from compound 5 to compound 6.

A more detailed description of preparing the compounds of the present invention is provided in the Examples section below.

The present invention also relates to the use of a light emitting material comprising the above-described compounds in the emitting layer of an organic light emitting device (OLED).

Further, the present invention relates to the use of a light emitting material as dopant in a host layer, thus functioning as an emissive layer in an OLED.

If the light emitting material is used as a dopant in a host layer, it is generally used in an amount of at least 1 % wt, preferably at least 3 % wt, and more preferably at least 5 % wt with respect to the total weight of the host and the dopant. Further, it is generally used in an amount of at most 25 % wt, preferably at most 20 % wt, and more preferably at most 15 % wt.

The present invention is also directed to an organic light emitting device (OLED) comprising an emissive layer (EML), wherein said emissive layer comprises the light emitting material described above. The OLED can optionally comprise a host material (wherein the light emitting material is preferably present as a dopant), wherein said host material is adapted to luminesce when a voltage is applied across the device structure.

The OLED generally comprises: a glass substrate; an anode which is a generally transparent anode, such as an indium-tin oxide (ITO) anode; a hole transporting layer (HTL); an emissive layer (EML); an electron transporting layer (ETL); and a cathode, which is generally a metallic cathode, such as an aluminium layer.

The OLED according to the present invention can be prepared by the routine methods and materials for preparing an OLED, except that the anthracene compound of Formula I, for example, is used to form at least one of the organic material layers. For example, the OLED according to the present invention can be prepared by first depositing a metal, a metal oxide having conductivity, or an alloy thereof on a substrate using a physical vapour deposition process, such as sputtering and e-beam evaporation, to form an anode. Then, an organic material layer comprising a hole injecting layer, a hole transporting layer, a light emitting layer, and an electron transporting layer is formed on the anode. Finally, a material which can be used as a cathode is deposited on the organic material layer. Alternatively, an OLED can be prepared by sequentially depositing a cathode material, an organic material layer, and an anode material on a substrate, thus preparing the above-described OLED with a reverse structure.

Further, the organic material layer can be prepared to have a fewer number of layers, using a variety of host materials (e.g., polymeric materials) and by means of a solvent process rather than a deposit process, such as spin coating, dip coating, doctor blading, screen printing, ink jet printing, and heat transfer processes.

If the anthracene compound of the present invention is used in the solvent process, it is typically used in an amount of at least 1% wt, preferably of at least 3% wt, more preferably of at least 5% wt with respect to the total weight of organic solvents, and generally at most 25% wt, preferably at most 20% wt, more preferably at most 15% wt.

As for the hole conducting emissive layer, one may have an exciton blocking layer, notably a hole blocking layer (HBL) between the emissive layer and the electron transporting layer. As for the electron conducting emissive layer, one may have an exciton blocking layer, notably an electron blocking layer (EBL) between the emissive layer and the hole transporting layer. The emissive layer may be equal to the hole transporting layer, in which case the exciton blocking layer is near or at the anode, or to the electron transporting layer, in which case the exciton blocking layer is near or at the cathode.

The emissive layer may be formed with a host material in which the above-described light emitting material resides as a guest or, alternatively, may consist essentially of the light emitting material. In the former case, the host material may be a hole transporting material selected from substituted tri-aryl amines. Alternatively, the emissive layer is formed with a host material, in which the light emitting material resides as a guest. The host material may be an electron transporting material selected from the group consisting of metal quinoxolates (e.g., aluminium quinolate (Alq₃), lithium quinolate (Liq)), oxadiazoles, and triazoles.

Optionally, the emissive layer may contain a polarization molecule, which is present as a dopant in the host material and has a dipole moment that generally affects the wavelength of the light emitted when the light emitting material used as the dopant luminesces.

A layer formed of an electron transporting material is advantageously used to transport electrons into the emissive layer comprising the light emitting material and the optional host material. The electron transporting material may be an electron-transporting matrix selected from the group consisting of metal quinoxolates (e.g., Alq₃, Liq), oxadiazoles, and triazoles. A specific example of the electron transporting material is tris-(8-hydroxyquinoline)aluminium ("Alq₃") having the following formula:

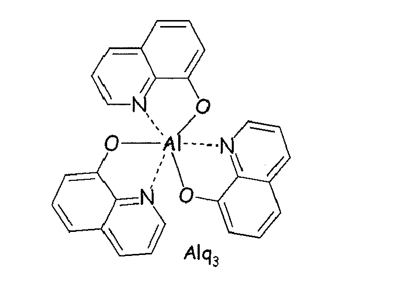

A layer formed of a hole transporting material is advantageously used to transport holes into an emissive layer comprising the above-described light emitting material and the optional host material. An example of the hole transporting material is *N,N*'-bis(3-methylphenyl)-*N,N*'-diphenylbenzidine ("TPD") having the following formula:

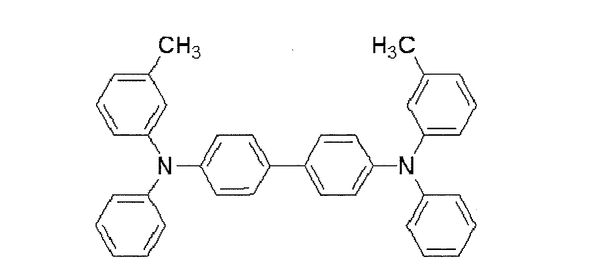

A cathode is located above the electron transportation layer. The cathode injects electrons into the electron transportation layer. As materials for the cathode, a metal having a low work function is preferable. Particularly, examples of metals include, but are not limited to, tin, magnesium, indium, calcium, sodium, lithium, aluminum, silver, and an alloy thereof. Additionally, an electrode with a double-layered structure, such as lithium fluoride and aluminum, lithium oxide and aluminum, strontium oxide and aluminum, etc., can be used. Although aluminum is known to have a work function of 4.2 eV, which is not low enough for efficient electron injection, a thin layer of insulating material enhances the electron injection by tunneling effect.

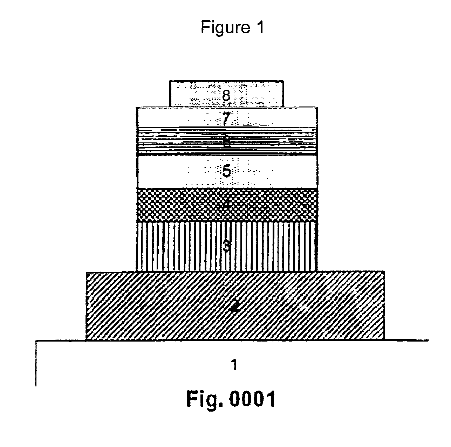

The OLED of the present invention preferably has a multilayer structure, as depicted in Figure 1, where: 1 is a glass substrate; 2 is an ITO layer; 3 is a HIL comprising poly(3,4-ethylenedioxythiophene):poly (styrenesulfonate) (PEDOT/PSS); 4 is a HTL comprising TPD; 5 is an EML comprising the compound of Formula I as a light emitting material; 6 is an ETL comprising Alq₃; 7 is a lithium fluoride (LiF) layer; and 8 is an aluminium layer cathode.

The compounds according to the present invention can also be used in an organic electronic device, such as an organic solar cell, an organic photoconductor, and an organic transistor, according to a principle similar to that applied to the OLED of the present invention.

The following examples are provided to illustrate embodiments of the present invention but are by no means intended to limit its scope.

### EXAMPLES

### Example 1 - Synthesis of (7-Bromonaphthalen-2-yl)triisopropylsilane

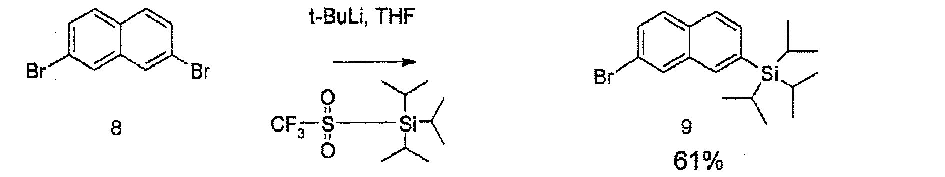

To a solution of 2,7-dibromonaphthalene 8 (10.4 g, 0.036 mol) in THF (300 ml) at -78°C was added 23 ml of 1.7 M t-BuLi solution in pentane. The mixture was stirred at -78°C for 1 hour and triisopropylsilyl(TIPS)-triflate (9.17 ml, 0.036 mol) was added while the reaction mixture temperature was maintained below -60°C. The reaction mixture was stirred overnight and allowed to reach the room temperature. The workup involved addition of aqueous sat. NH₄Cl (100 ml) and extraction of the product with methyl t-butyl ether (MTBE). After drying over anhydrous Na₂SO₄ and filtration, the MTBE solution was concentrated under reduced pressure. The product was purified on a 120 g SiO₂ pre-packed column, using cyclohexane for elution. The product-containing fractions were concentrated to yield 8 g (61 %) of 2-bromo-7-triisopropylsilyl naphthalene 9.

### Example 2 - Synthesis of Triisopropyl(7-(4,4,5,5-tetramethyl-1,3,2-dioxaborolan-2-yl)naphthalen-2-yl)silane

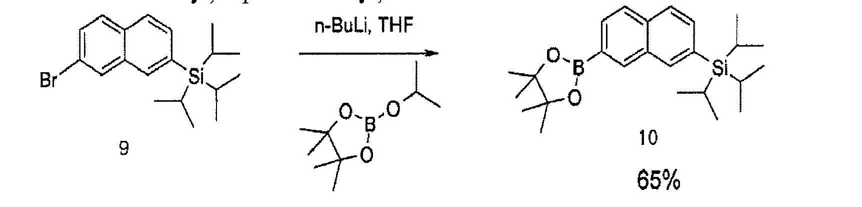

A solution of 2-bromo-7-triisopropylsilyl naphthalene 9 (7.10 g, 0.027 mol) from Example 1 in dry freshly distilled tetrahydrofuran(THF) (500 ml) was cooled down to -78°C. At this temperature, 32.4 ml of n-BuLi 2.5 M solution in hexanes was added. The cooling bath was removed and the reaction mixture was stirred at ambient temperature for 3 hours. After cooling down again to -78°C, 2-isopropoxy-4,4,5,5-tetramethyl-1,3,2-dioxaborolane (7.5 g, 0.040 mol) was added dropwise. Then, the mixture was allowed to warm up gradually to room temperature overnight. A workup of the reaction mixture involved the addition of aqueous saturated NH₄Cl (100 ml) and extraction with MTBE. The organic phase was dried over Na₂SO₄ and filtered and concentrated under reduced pressure. The residue was purified on a 120 g SiO₂ pre-packed column using a gradient of ethyl acetat (0-10%) in hexanes to yield 7.37g (65%) of triisopropyl(7-(4,4,5,5-tetramethyl-1,3,2-dioxaborolan-2-yl)naphthalen-2-yl)silane 10.

### Example 3 - Synthesis of 2-(7-(Triisopropylsilyl)naphthalen-2-yl)anthracene-9,10-dione

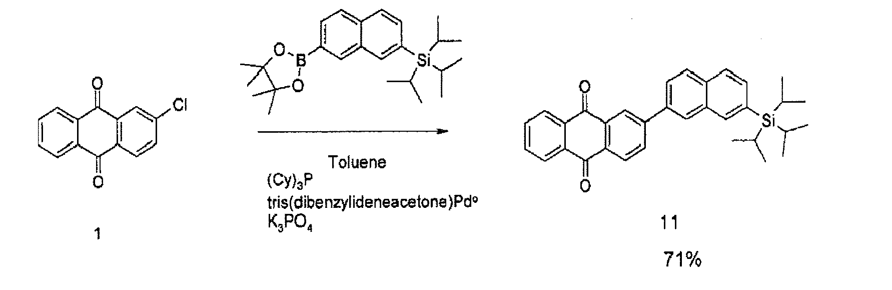

2-Chloroanthraquinone 1 (3.6g, 0.015 mol), 2,7- tetramethyl dioxaborolane triisopropylsilyl naphthalene 10 (7.37 g, 0.015 mol) from Example 2, tricyclohexyl phosphine (0.840 g, 0.0029 mol), tris(dibenzylidenacetone)Pd° (2.7 g, 0.03 mol), K₃PO₄ (6.2 g, 0.03 mol) were all weighed under nitrogen and suspended in 100 ml degassed toluene. The reaction mixture was refluxed overnight, filtered, and washed with CH₂Cl₂ (500 ml). The filtrate was purified with hexanes on 120 g SiO₂ pre-packed column to obtain 10.5 g (71 %) of 2-(7-(triisopropylsilyl)naphthalen-2-yl)anthracene-9,10-dione 11.

### Example 4 - Synthesis of 9,10-Bis(4-methylnaphthalen-1-yl)-2-(7-(triisopropylsilyl)naphthalen-2-yl)-9,10-dihydroanthracene-9,10-diol

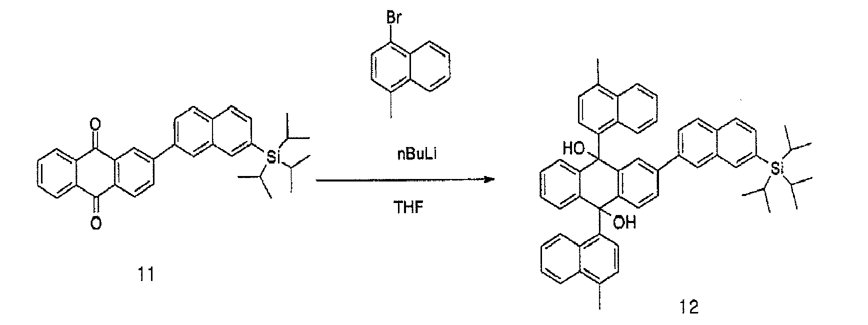

To a mixture of 4-methyl-1-bromonaphthalene (5.5 g, 0.025 mol) in 300 ml THF at -78°C were added 17 ml of 2.5M n-BuLi solution in hexanes. The reaction mixture was stirred at ambient temperature for 3 hours, cooled down again to -78°C, and treated with a solution of 2-(7-(triisopropylsilyl)naphthalen-2-yl)anthracene-9,10-dione 11 (10 g) from Example 3 in THF (100 ml). The mixture was stirred overnight and allowed to reach the room temperature. A workup of the reaction mixture involved the addition of NH₄Cl (500 ml) and extractions with MTBE (3 x 200 ml) and ethyl acetate (100 ml). The organic phase was dried over Na₂SO₄ and filtered. The filtrate was concentrated under reduced pressure and the residue purified on 120 g SiO₂ column with hexanes to give 4.43 g (69%) of 9,10-bis(4-methyl-naphthalen-1-yl)-2-(7-(triisopropylsilyl)naphthalen-2-yl)-9,10-dihydroanthracene-9,10-diol 12.

### Example 5 - Synthesis of (7-(9,10-Bis(4-methylnaphthalen-1-yl)anthracen-2-yl)naphthalen-2-yl)triisopropylsilane

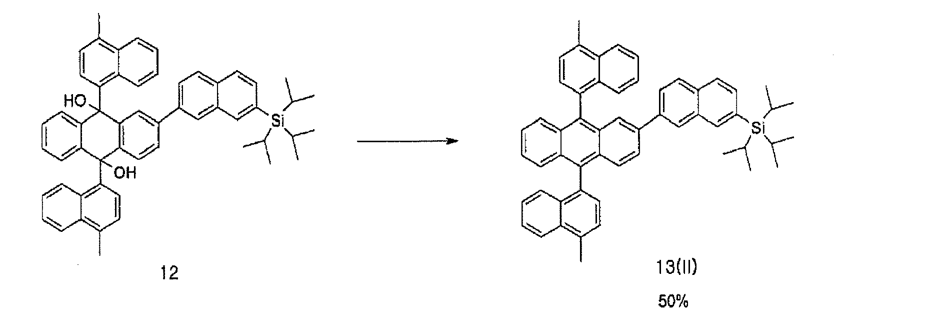

To a mixture of dialcohol 12 (4.2 g, 0.0054 mol) from Example 4 in CH₃COOH (50 ml), KI (2.1 g, 0.012 mol) and NaH₂PO₂ (1.90 g, 0.02 mol) were added. The reaction mixture was stirred for 3 hours at 100°C and cooled to room temperature. Upon cooling, a yellow precipitate appeared, which was filtered and washed with water. The yellow solid was dissolved in CH₂Cl₂ and washed with 1 N aqueous NaOH. The solution was dried over anhydrous Na₂SO₄ and filtered. The filtrate was concentrated under reduced pressure and the residue was purified on neutral Al₂O₃ 3x40g columns with hexanes to give 2 g (50%) of (7-(9,10-bis(4-methylnaphthalen-1-yl)anthracen-2-yl)naphthalen-2-yl)triiso-propylsilane 13. This material sublimed at 250°C and 10⁻⁶ Torr vacuum.

### Example 6 - Preparation of Light Emitting Diodes Using the Compound of Formula II

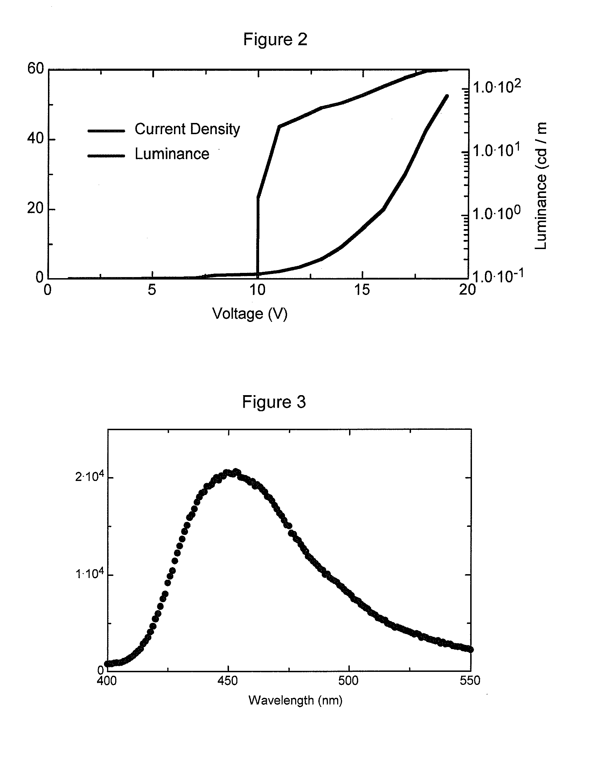

A glass substrate, on which ITO (indium tin oxide) was coated, was washed with distilled water and then with a solvent, such as isopropyl alcohol, acetone, methanol, etc., and the substrate was dried. On the dried ITO transparent electrode, PEDOT/PSS was spin-coated with a thickness of 100 nm to form a hole injection layer. Triphenyldiamine (TPD), which transports holes, was vacuum deposited thereon (35 nm), and the compound of Formula II that performs the function of the emitting layer was vacuum deposited with a thickness of 41.6 nm. On the emitting layer, Alq₃, that performs the function of injecting and transporting electrons, was vacuum deposited with a thickness of 34 nm. On the electron injection and transportation layers, lithium fluoride (LiF) with a thickness of 1 nm and aluminum with a thickness 180 nm were sequentially deposited to form a cathode. All vacuum deposition was conducted under the pressure of 10⁻⁵ torr. On the prepared organic electroluminescent device, a forward electric field was added and, as a result, a blue spectrum was observed (see Figures 2 and 3).

Although the invention has been described in detail for the purpose of illustration, it is understood that such detail is solely for that purpose, and variations can be made therein by those skilled in the art without departing from the spirit and scope of the invention which is defined by the following claims.

## Claims

1. A compound of Formula I: 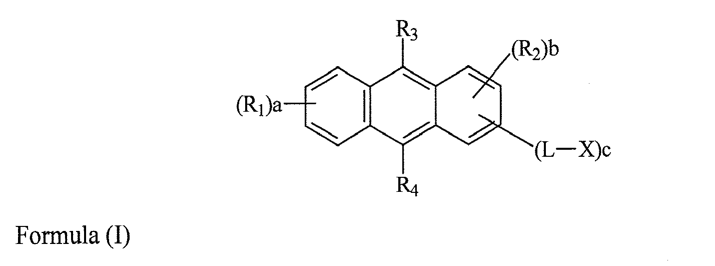 wherein:
R1, R2, R3, and R4 are the same or different at each occurrence and independently selected from the group consisting of -H, halogen, -NO2, -CN, a straight or branched C1-20 alkyl, a C3-20 cyclic alkyl, a straight or branched C1-20 alkoxy, a C1-20 dialkylamino, a C4-14 aryl, and a C4-14 heteroaryl which may be substituted by one or more non aromatic radicals, wherein a plurality of substituents R1, R2, R3, R4 may in turn together form a further mono- or polycyclic ring system, optionally aromatic;
L is a single bond or a divalent radical derived from at least one selected from the group consisting of: a straight or branched C1-20 alkyl, a C3-20 cyclic alkyl, a straight or branched C1-20 alkoxy, a C1-20 dialkylamino, a C4-14 aryl, and a C4-14 heteroaryl which may be substituted by one or more non aromatic radicals, wherein a plurality of substituents L may in turn together form a further mono- or polycyclic ring system, optionally aromatic, with the proviso that at least one of R1-R4 and L includes a naphthyl moiety;
X is selected from the group consisting of -SiR5R6R7, wherein R5, R6 and R7 are the same or different at each occurrence and independently selected from the group consisting of -H, halogen, -NO2, -CN, a straight or branched C1-20 alkyl, a C3-20 cyclic alkyl, a straight or branched C1-20 alkoxy, a C1-20 dialkylamino, a C4-14 aryl, and a C4-14 heteroaryl which may be substituted by one or more non aromatic radicals, wherein a plurality of substituents R5, R6 and R7 may in turn together form a further mono- or polycyclic ring system, optionally aromatic, with the proviso that all of R5, R6 and R7 cannot be phenyl simultaneously; and
a, b, and c are the same or different at each occurrence and are an integer from 0 to 4, wherein c>0 and b+c =4;
or a pharmaceutically acceptable salt thereof.

2. The compound according to claim 1, wherein R1,R2, R3, R4 are the same or different at each occurrence and independently selected from the group consisting of H and , 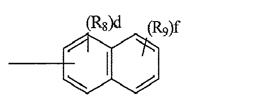 wherein R8 and R9 are the same or different at each occurrence and independently selected from the group consisting of -H, halogen, -NO2, -CN, a straight or branched C1-20 alkyl, a C3-20 cyclic alkyl, a straight or branched C1-20 alkoxy, a C1-20 dialkylamino, a C4-14 aryl, and a C4-14 heteroaryl which may be substituted by one or more non aromatic radicals, wherein a plurality of substituents R8 and R9 may in turn together form a further mono-or polycyclic ring system, optionally aromatic, d is an integer from 0 to 3, and f is an integer from 0 to 4.

3. The compound according to claim 1 or 2, wherein at least one of R5, R6, and R7 contains more than one carbon atom.

4. The compound according to claim 3, wherein X is -Si(t-Bu)3 or -(CH3)2SiC8H17.

5. The compound according to any one of claims 1 to 4, wherein R3 = R4 =

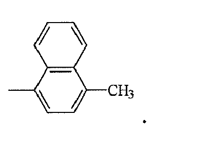

6. The compound according to any one of claims 1 to 5, wherein L is a single bond or , 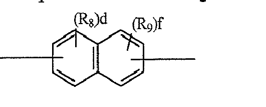 wherein R8 and R9 are the same or different at each occurrence and selected from the group consisting of -H, halogen, -NO2, -CN, a straight or branched C1-20 alkyl, a C3-20 cyclic alkyl, a straight or branched C1-20 alkoxy, a C1-20 dialkylamino, a C4-14 aryl, and a C4-14 heteroaryl which may be substituted by one or more non aromatic radicals, wherein a plurality of substituents R8 and R9 may in turn together form a further mono- or polycyclic ring system, optionally aromatic, d is an integer from 0 to 3, and f is an integer from 0 to 4.

7. The compound according to claim 6, wherein the compound has the following formula:

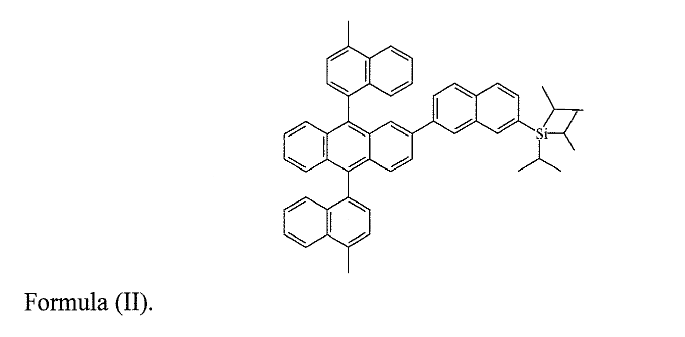

8. The compound according to claim 6, wherein the compound has the following formula:

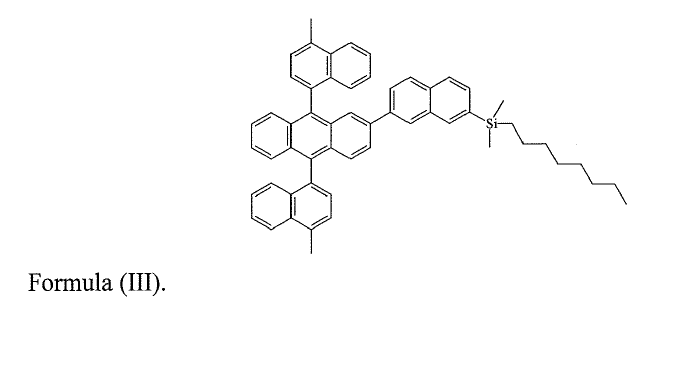

9. The compound according to claim 6, wherein the compound has the following formula:

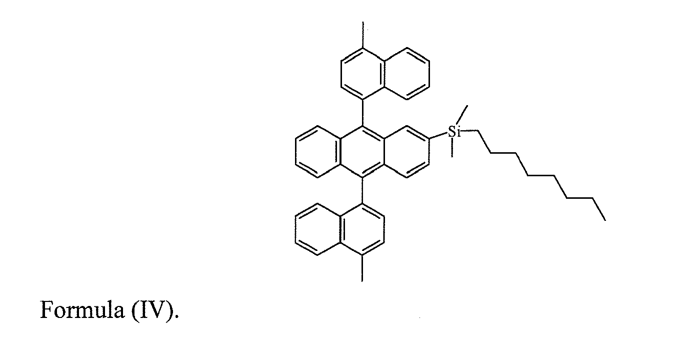

10. A light emitting material comprising the compound according to any one of claims 1 to 9.

11. Use of the light emitting material according to claim 10 in the emissive layer of an organic light emitting device.

12. Use of the light emitting material according to claim 10 as a dopant in a host layer, under conditions effective to function as an emissive layer in an organic light emitting device.

13. An organic light emitting device comprising an emissive layer, **characterized in that** said emissive layer comprises the light emitting material according to claim 10 and optionally a host material.

14. A display device comprising the organic light emitting device according to claim 13.
